(19) Europäisches Patentamt

European Patent Office

Office européen des brevets

(11) Publication number : **0 397 131 B1**

## (12) EUROPEAN PATENT SPECIFICATION

(45) Date of publication of patent specification :
**05.04.95 Bulletin 95/14**

(51) Int. Cl.[6] : **H01L 21/285,** C23C 16/02, C23C 16/08, H01L 21/768

(21) Application number : **90108719.7**

(22) Date of filing : **09.05.90**

(54) Method of manufacturing a contact in semiconductor devices.

(30) Priority : **09.05.89 JP 117128/89**
**09.03.90 JP 58918/90**

(43) Date of publication of application :
**14.11.90 Bulletin 90/46**

(45) Publication of the grant of the patent :
**05.04.95 Bulletin 95/14**

(84) Designated Contracting States :
**DE FR GB**

(56) References cited :
EP-A- 0 117 542
EP-A- 0 174 743
DE-A- 3 815 569
US-A- 4 338 354
PATENT ABSTRACTS OF JAPAN vol. 13, no. 56 (C-566) 08 February 1989,
& JP-A-63 248800 (TOSHIBA TUNGALOY CO LTD) 17 October 1988,
PATENT ABSTRACTS OF JAPAN vol. 6, no. 259 (E-149) 17 December 1982, & JP-A-57 157525

(56) References cited :
PATENT ABSTRACTS OF JAPAN vol. 12, no. 301 (C-521)(3148) 16 August 1988, & JP-A-63 072881
PATENT ABSTRACTS OF JAPAN vol. 13, no. 84 (C-572) 27 February 1989, & JP-A-63 270467
PATENT ABSTRACTS OF JAPAN vol. 6, no. 118 (C-111) 02 July 1982, & JP-A-57 047706
PATENT ABSTRACTS OF JAPAN vol 8, no. 3 (C203) 7 January 1984, & JP-A-58 172206

(73) Proprietor : **FUJITSU LIMITED**
**1015, Kamikodanaka**
**Nakahara-ku**
**Kawasaki-shi Kanagawa 211 (JP)**

(72) Inventor : **Ohba, Takayuki, c/o FUJITSU**
**LIMITED Patent Dept.**
**1015 Kamikodanaka,**
**Nakahara-ku**
**Kawasaki-shi, Kanagawa 211 (JP)**

(74) Representative : **Sunderland, James Harry et al**
**HASELTINE LAKE & CO**
**Hazlitt House**
**28 Southampton Buildings**
**Chancery Lane**
**London WC2A 1AT (GB)**

EP 0 397 131 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to semiconductor device manufacture, and is particularly concerned with surface treatment and formation of contacts.

In recent years, as higher packing densities are provided for semiconductor devices, multilayer wirings are often employed and the sizes of contacts for wirings have been reduced, leading to increased contact resistances.

Further, depths of p-n junctions formed in semiconductor devices have become less. Thereby, leakage current resulting from damage at a p-n junction in a contact area is increased.

When contact resistance becomes large, to a level such that its effects cannot be neglected in terms of channel resistance and leakage current, for channel current, since these factors have a significant effect on device operations, reduction of contact resistance and leakage current become very desirable.

Additionally, substrate flatness is an important factor in relation to reliability of wiring and stability of wiring with respect to thermal cycling.

When forming contact layers using an aluminium system, or refractory metal, on a silicon substrate by a sputtering method or a CVD method, it is known that the cleanliness of the substrate surface is an important factor so far as contact resistance is concerned.

For instance, when titanium (Ti) is formed on a Si substrate by a sputtering method, formation of silicide $(TiSi_x)$ generated through reaction of Ti and Si, can become non-uniform due to contamination of the Si surface (by natural oxide, organic substances, etc.). Thereby, contact resistance may be increased. Moreover, in a case in which a tungsten (W) layer is grown by a CVD method, since nucleation does not occur smoothly on a natural oxide, the desired layer does not grow, or is grown with irregular corrosion.

Therefore, surface cleanliness is important for attaining low contact resistance when forming contacts.

As surface treatment of a lower base layer, a wet etching method or a dry etching method such as a plasma etching method and hydrogen reduction method have been employed. However, in such a wet or dry etching method, side products may easily be generated and, with the plasma etching method, surface damage may occur. Moreover, when reduction by hydrogen is employed, thermal damage may occur, a diffused layer may spread and aluminium wirings may be melted easily due to the high temperature (800°C) used, and thereby device characteristics may be adversely affected.

As indicated above, a satisfactory surface processing method has not previously been provided.

In order to realise low contact resistance, refractory metals (for example tungsten W or titanium Ti), silicides thereof (for example $WSi_x$, $TiSi_x$) or nitrides thereof (for example WN, TiN) are used in place of aluminium (Al), the most widely used conventional wiring material. These refractory metal materials, when used for contacts, simultaneously perform the role of barrier metal for suppressing chemical reactions between substrate and (any overlying) aluminium wirings. Namely, even when a contact involves a shallow junction, spike generated by chemical reactions between substrate materials and wiring materials do not damage these shallow junctions. Therefore, such barrier metal can effectively prevent leakage current caused by damage to junction areas.

With regard to contact metal layers, methods for sputtering Al related material such as aluminium (Al), AlSi and AlCu have been employed. However, in such cases, disadvantages have existed in that AlSi allows increase of contact resistance by segregation of Si, or in that defective wirings can occur due to the low migration resistance (electro migration or stress migration) of Al and Al alloys.

This migration problem has been solved by employing a CVD method using tungsten W for the contact metal Layer or wirings. Namely, coverage of Al is improved by the use of a burying method and defective wirings do not occur, due to the high migration resistance of wirings based on tungsten W. However, this CVD method suffers a disadvantage in that Si or fluorine F, which is an element of a reactant gas forming element, is easily incorporated into the tungsten W layer when a low temperature reducing reaction using silane $(SiH_4)$, etc., is employed, and thereby a contact resistance becomes larger and coverage rate is reduced. On the other hand, CVD of tungsten W using a reducing reaction using hydrogen $(H_2)$ is characterised by the provision of a Large coverage rate but is also accompanied by a disadvantage in that corrosion of Si is significant and leakage current is manifest due to the high growth temperature employed and the generation of corrosive gas.

A tungsten W layer obtained by a CVD method also suffers a disadvantage in that layer peeling may occur as a result of the poor adhesive property of this layer to an $SiO_2$ layer. Therefore, an adhesive layer which also functions as a contact barrier layer, for example of TiN, is first formed by a sputtering method and then a tungsten W layer is formed thereon by a CVD method. However, this adhesive layer exhibits poor coverage of stepped portions, due to employment of a sputtering method, and abnormal growth, zero growth or peeling of the tungsten layer may occur at contact regions.

Patent Abstracts of Japan, Vol. 6-118 [C 111] & JP-A-57 047707 disclose the manufacture of a lump of silicon nitride containing Ti by blowing gaseous sources for depositing Si, N and Ti at a hot substrate after mixing at specified flow rates. $NH_3$, $N_2H_4$ or the like is used as a gaseous source for depositing nitrogen. Gaseous Si halide or hydride such as $SiCl_4$ or $SiH_4$ is used as a gaseous source for depositing Si

and vapor or $TiCl_4$, $TiBr_4$ or the like is used as a compound source for depositing Ti.

Patent Abstracts of Japan, Vol. 6-259 [E 149] & JP-A-57 157525 disclose that removal of C coated, and a clean surface, can be obtained after etching when the surface has been etched in a gas plasma of a compound containing C, by mixing $NH_3$ or $N_2H_4$, or exposing the surface in the plasma of $NH_3$ or $N_2H_4$ or the mixed gas of $N_2$ and $H_2$.

According to the present invention there is provided a method of manufacturing a contact on a substrate surface, including forming a conducting material layer on an exposed surface region of the substrate structure, which exposed surface region may be that of a semiconductor or conductor material of the substrate structure, and cleaning an exposed surface region of the substrate, prior to forming the conducting material layer, using a gas comprising a nitrogen hydride or a nitrogen hydride derivative, then forming the conducting material layer containing a metal on the substrate using a gas mixture containing a gas comprising a nitrogen hydride or a nitrogen hydride derivative and a gas comprising a metal halide or an organic metal composition or a metal complex, without intermediate exposure of the substrate to atmospheric conditions.

An embodiment of the present invention can provide for contact regions of low contact resistance to be obtained, through cleaning of substrate surface.

An embodiment of the present invention can provide for contact regions to be obtained which suffer less leakage current.

An embodiment of the present invention can provide for contact regions to be obtained with desirable substrate surface flatness.

An embodiment of the present invention can provide for contact regions of high reliability to be obtained.

Embodiments of the present invention can employ (a) and (b), in the course of manufacture of contacts:-

(a) a substrate surface is exposed to a gas which is a nitrogen hydride or an organic nitrogen hydride and the surface is thereby cleaned.

(b) a barrier metal layer is formed by a CVD method using a mixed gas as a raw material, the gas comprising a metal halide or an organic metal composition or a metal complex and a nitrogen hydride or a derivative of nitrogen hydride, and thereafter a metal layer is formed by a CVD method using such mixed gas.

For surface processing and for growth of contact metal layering in accordance with an embodiment of the present invention, the reducing effect of, for example, hydrazine is utilised. Namely, a clean surface can be provided by utilising a nitrogen hydride or an organic nitrogen hydride such as hydrazine ($N_2H_4$) or methyl hydrazine ($CH_3N_2H_3$), maintaining the substrate temperature in the range of 200°C to 800°C, by a heating method using resistance heating or a method using a halogen lamp or an arc lamp, and by removing Si or metal impurity on the substrate surface, for example, Si oxide, metal oxide or organic substance through reduction thereof.

Further, since a nitrogen hydride or a derivative thereof has strong reactivity, it reacts with metal halides, organic metals or metal complexes, depositing metal nitrides or pure metals on a substrate. Since side products include volatile nitrogen compounds or low order hydrocarbons, these are not incorporated into the deposited metal (or nitride) and thereby contact resistance is not increased.

In such a CVD method, growth conditions may be set to the condition of surface reaction limited, growth layer thickness may be equalised, the growth layer may be deposited faithfully over the substrate surface including stepped portions, and a large coverage ratio may also be obtained. Moreover, in accordance with an embodiment of the present invention, a barrier metal layer may be grown by a CVD method on a cleaned substrate surface without exposing the surface to the air, with the contact metal layer successively grown by the CVD method by changing the reaction gas. Thereby, the respective CVDs are carried out and on the cleaned substrate surface, both resistivity and reflectivity of contact metal layer are improved in comparison with the layers provided by previously proposed methods and both contact hole coverage and p-n junction leakage current characteristics are also as much improved.

Accordingly, the present invention can provide a more optimum method for cleaning the surface of a substrate and for providing lower contact resistance when forming wiring materials on the surface of a base substrate.

Moreover, it is possible to sequentially form barrier metal layer and wiring materials within a series of processings including the surface treatment of a base substrate.

Reference is made, by way of example, to the accompanying drawings, in which:-

Fig. 1(a) is a schematic diagram illustrating in outline form a manufacturing apparatus used to form a contact region, in accordance with an embodiment of the present invention;

Fig. 1(b) is a schematic diagram illustrating in outline form contact manufacturing apparatus combining a substrate surface treatment chamber and two contact metal layer growth chambers, for carrying out an embodiment of the present invention;

Fig. 1(c) is a schematic diagram illustrating contact manufacturing apparatus combining two substrate surface treatment chambers, two contact metal layer growth chambers and two load lock chambers, for carrying out an embodiment of the present invention;

Fig. 2(a) is a diagram in which produced free energy (- $\Delta$ G) is plotted against absolute temperature (K) for a variety of chemical reactions related to an embodiment of the present invention;

Fig. 2(b) is a diagram in which time of deposition in $WF_6$ ambient is plotted against the value of sheet resistance of tungsten deposited on a substrate surface, after surface treatment using $N_2H_2(CH_3)_2$ has been effected, maintaining an Si substrate at 350°C, for assistance in explaining an embodiment of the present invention;

Fig. 3(a) is a schematic sectional view indicating the condition of a substrate to be carried into a manufacturing apparatus as shown in Fig. 1(a), (b) or (c) for surface treatment, in accordance with an embodiment of the present invention;

Fig. 3(b) is a schematic sectional view indicating the condition of the substrate after substrate surface contaminants have been reduced and eliminated by action of $N_2H_4$;

Fig. 4(a) is a schematic sectional view of a substrate after surface-cleaning treatment;

Fig. 4(b) is a schematic sectional view of a sample wherein a tungsten layer is formed by a CVD method within the contact hole seen in Fig 4(a), in accordance with an embodiment of the present invention;

Fig. 4(c) is a schematic sectional view of a sample wherein a TiN layer is formed on the entire surface as seen in Fig. 4(b), in accordance with an embodiment of the present invention;

Fig. 4(d) is a schematic sectional view of a sample wherein a tungsten layer is grown on the entire surface of the TiN layer of Fig. 4(c) and a tungsten wiring layer is formed by patterning the tungsten layer, in accordance with an embodiment of the present invention;

Fig. 5(a) is a graph indicating a relationship between contact resistance (R) per 1 $\mu$ m x 1 $\mu$ m and surface-cleaning treatment time for a W/Si($n^+$) contact provided in accordance with an embodiment of the present invention;

Fig. 5(b) is a graph indicating a relationship between diode leakage current and annealing time for a W/Si($n^+$) contact as per Fig. 5(a);

Fig. 6(a) is a schematic sectional view of a sample after completion of substrate surface-cleaning treatment in accordance with an embodiment of the present invention;

Fig. 6(b) is a schematic sectional view of the sample of Fig. 6(a) wherein a $TiN_2$ barrier metal layer is formed over a contact hole and interlayer insulation film, in accordance with an embodiment of the present invention;

Fig. 6(c) is a schematic sectional view of the sample of Fig. 6(a) wherein a tungsten contact layer is formed on the $TiN_2$ barrier metal layer of Fig.

6(b), in accordance with an embodiment of the present invention;

Fig. 6(d) is a schematic sectional view of a sample wherein the $TiN_2$ barrier metal layer and tungsten contact layer are buried in the contact hole, in accordance with an embodiment of the present invention;

Fig. 7(a) is a graph in which resistivity of a tungsten contact layer is plotted against growth temperature (substrate temperature) for a CVD method employed in accordance with an embodiment of the present invention;

Fig. 7(b) is a graph in which reflectivity of the tungsten contact layer is plotted against growth temperature (substrate temperature) for the CVD method;

Fig. 7(c) is a diagram comparing coverage ratio of a contact hole provided by a tungsten contact layer manufacturing method embodying the present invention with that provided by a previous method;

Fig. 8(a) is a schematic sectional view of a sample before surface-cleaning treatment is effected, prior to contact formation for multilayer wirings, in accordance with an embodiment of the present invention;

Fig. 8(b) is a schematic sectional view of the sample with a tungsten contact layer is formed in a contact hole, after surface-cleaning treatment is carried out using apparatus as illustrated in Fig. 1(a), (b) or (c), in accordance with an embodiment of the present invention;

Fig. 8(c) is a schematic sectional view of the sample with a $TiN_2$ barrier metal layer formed over the part shown in Fig. 8(b), in accordance with an embodiment of the present invention;

Fig. 8(d) is a schematic sectional view of the sample wherein a tungsten layer is grown over the entire TiN layer shown in Fig. 8(c) and a tungsten wiring layer is formed by patterning the tungsten layer, in accordance with an embodiment of the present invention;

Fig. 8(e) is a schematic sectional view of the sample wherein a contact hole is provided in an insulating interlayer formed covering the tungsten wiring of Fig. 8(d), in accordance with an embodiment of the present invention; and

Fig. 8(f) is a schematic sectional view of the sample wherein the substrate surface exposed in the contact hole of Fig. 8(e) is cleaned, a tungsten layer is grown thereon and an aluminium layer for a second wiring layer is immediately formed over the entire part shown, in accordance with an embodiment of the present invention.

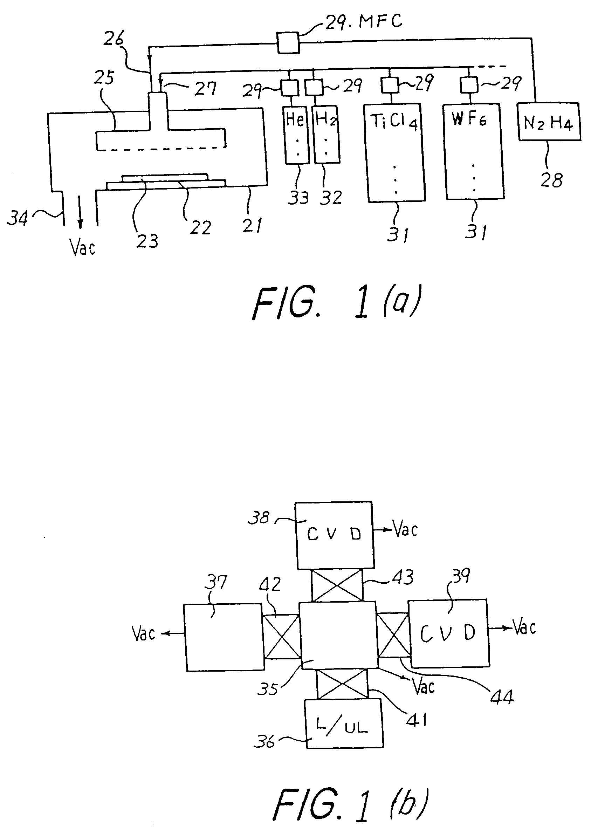

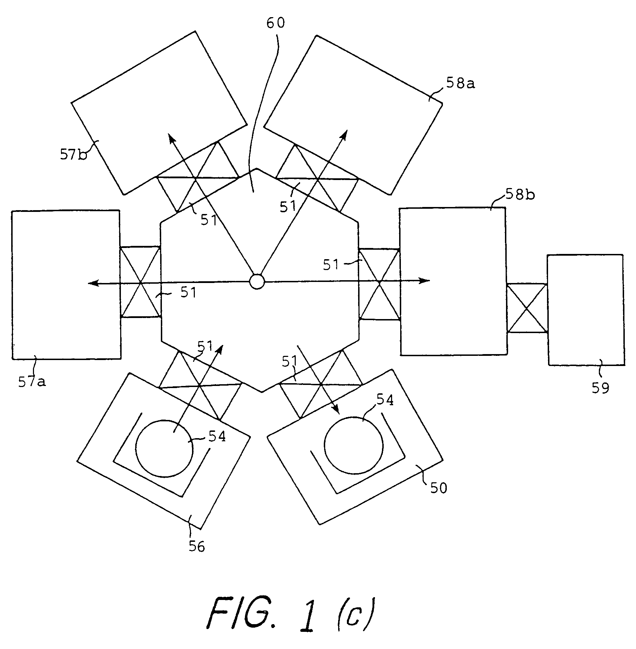

Exemplary embodiments of the present invention will be explained with reference to Figs. 1 to 8. In those Figures, like elements are designated by the like reference signs throughout.

First Embodiment:

Fig. 1(a) is a schematic diagram for assistance in explaining a manufacturing apparatus used for manufacturing contacts in accordance with this embodiment and other embodiments of the present invention.

In the apparatus shown in this Figure, a reactant gas for substrate surface treatment and a reactant gas for forming a contact metal layer are introduced respectively into a reaction chamber 21 through a gas shower 25 from gas supply ports 26 and 27 and exhausted via a gas exhaust port 34. A substrate 23 to be surface-treated is placed on a quartz window 22 provided in the lower side in the reaction chamber 21. At the lower side of (below) quartz window 22, a heater is provided (not illustrated) and thereby substrate temperature is controlled to a determined value.

The $N_2H_4$ gas 28, for substrate surface treatment, is guided to the reaction chamber 21 through the gas supply port 26 and via a mass flow controller 29. Since $N_2H_4$ 28 decomposes, if it is in a liquid or high concentration condition, through contact with a metal surface, it is desirable that the $N_2H_4$ is prevented from having direct contact with metal by effecting teflon processing of the piping used for supplying the reactant gas.

Reactant gas 31 such as $TiCl_4$, $WF_6$ and carrier gas such as Ar gas 33, $H_2$ 32, for forming a contact metal layer, are guided to the reaction chamber 21 through the gas supply port 27 and via the flow controllers 29.

Gas pressure in the reaction chamber 21 is controlled to a predetermined value by adjusting speed of exhaustion from the exhaust port 34 by a vacuum pump and flow rate of gas introduced through the gas supply ports 26, 27.

The apparatus illustrated in Fig. 1(a) provides for surface treatment of a substrate and growth of contact metal layer in the same reaction chamber by exchange of gas in the chamber.

Fig. 1(b) is a diagram for assistance in explaining a manufacturing apparatus in which substrate surface treatment and growth of a plurality of contact metal layers are carried out in different reaction chambers, without the substrate being exposed to atmospheric conditions, in accordance with this and other embodiments of the present invention.

In Fig. 1(b), a load lock chamber 35 is connected with a load/unload (L/UL) chamber 36, a surface processing chamber 37 and CVD chambers 38, 39 similar to that in Fig. 1 through gate valves 41, 42, 43, 44. A substrate to be processed is carried to any of the surface treatment chamber 37 and CVD chambers 38 or 39 from the L/UL chamber 36 and is then carried out again from the L/UL chamber 36 after completion of necessary processing. For example, an Si substrate surface is cleaned in the surface treatment chamber 37, a tungsten layer is grown in the CVD chamber 38 and then a TiN layer is grown in the CVD chamber 39. Or, alternatively, it is possible that the TiN layer is formed first and the tungsten layer is then formed subsequently. During this process, the chambers 37, 38, 39 can be kept in their normal operating conditions.

Fig 1(c) illustrates an apparatus larger in size than that illustrated in Fig. 1(b), for use in accordance with this and other embodiments of the present invention. Using one system path, a substrate 54 introduced from an inlet load lock chamber 56 is processed in a surface treatment chamber 57a, passing through a valve 51 and a central chamber 60, then moved to a growth chamber 58a through the central chamber 60 after surface treatment and is then taken out from an outlet load lock chamber 50 through the central chamber 60 after layer growth. Moreover, using another system path, the substrate 54 introduced from the inlet load lock 56 is carried into a surface treatment chamber 57b through a valve 51 and the central chamber 60, then moved to a growth chamber 58b through the central chamber 60 after the surface treatment, and is then taken out from the outlet load lock chamber 50 through the central chamber 60 after layer growth. Exhaust apparatuses are not comprehensively shown; they are merely represented by the exhaust apparatus 59.

A method of cleaning a substrate surface in accordance with this embodiment of the invention, as effected using manufacturing apparatus shown in Fig. 1(a), will now be explained. Of course, it is possible to carry out this cleaning method with the apparatuses shown in Fig. 1(b) and Fig. 1(c).

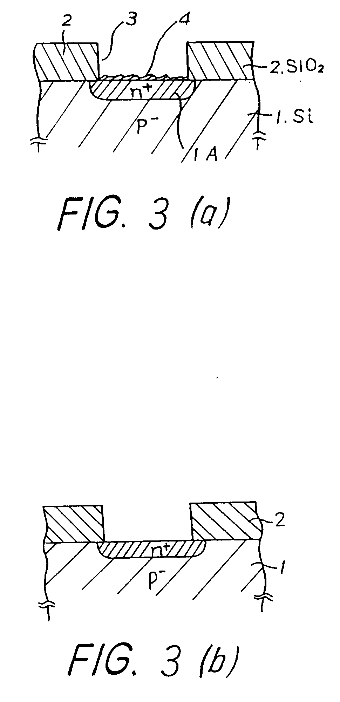

Fig. 3(a) illustrates the condition of a substrate before it is carried into the manufacturing apparatus of Fig. 1(a). The substrate will hereafter be called a sample. In this sample, a contact hole 3 is opened in an $SiO_2$ film 2 formed to a thickness of 5000 Å on a $p^-$ -Si substrate 1, and a shallow p-n junction is formed by forming an $n^+$ layer 1A on the substrate 1 by ion implantation of As. Such a sample is carried into the manufacturing apparatus of Fig. 1(a) and is then placed on the quartz window 22 provided at the lower side of the reaction chamber 21.

On the exposed substrate, there exist impurities 4 such as residual etching material, intentionally deposited contaminants or natural oxides, etc. Therefore, the surface is cleaned by keeping the substrate temperature at 300°C for 30 seconds. A typical condition established in the reaction chamber is as follows. As reactant gas $N_2H_4$ is used, at 10 SCCM flow, and as carrier gas any one of $H_2$, He or Ar is used, at 10 SCCM flow, respectively. The pressure in the reaction chamber 21 is set to 0.1 Torr and the substrate temperature may be set within the range from 200 to 900°C but an optimum temperature is 300°C.

Chemical reactions between $N_2H_4$ and contami-

nants are as follows.

If the contaminant is $SiO_2$:-

$$N_2H_4 + SiO_2 \longrightarrow N_2 + 2H_2O + Si \quad (1)$$

or

$$2N_2H_4 + SiO_2 \longrightarrow 2N_2 + 2H_2O + SiH_4 \quad (2)$$

If the contaminant is an organic substance:-

$$N_2H_4 + C_nH_m \longrightarrow N_2 + CH + H_2 \quad (3)$$

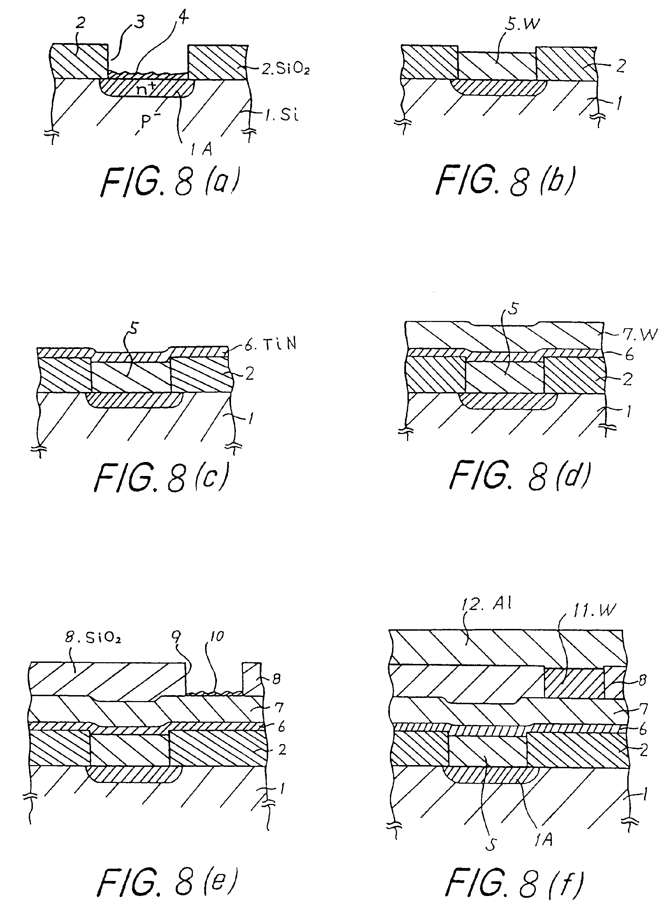

If the contaminant is $Al_2O_3$ (when the base substrate is formed by Al, refer to Fig. 8(f) concerning the fourth embodiment):-

$$N_2H_4 + (2/3)Al_2O_3 \longrightarrow N_2 + (4/3)Al + 2H_2O \quad (4)$$

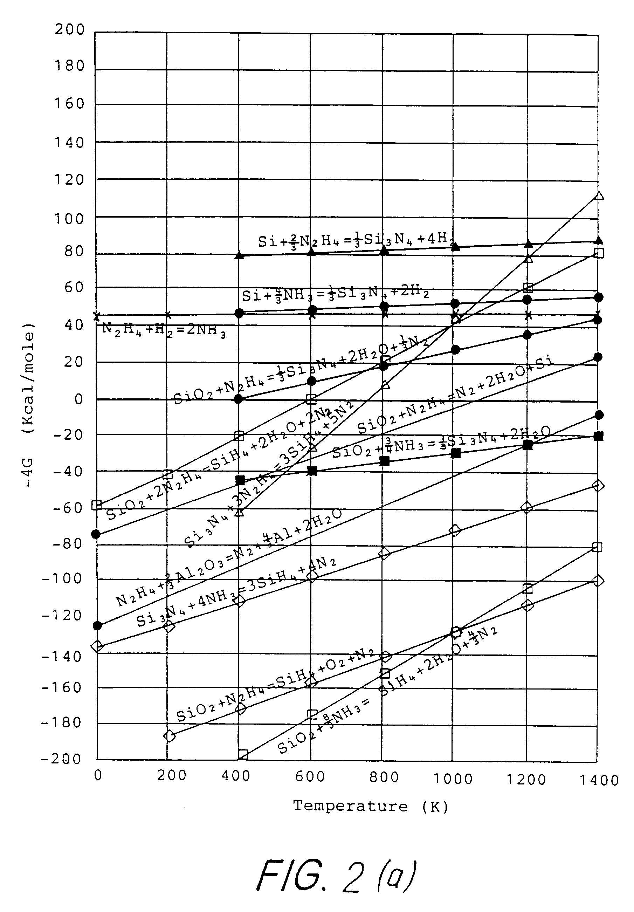

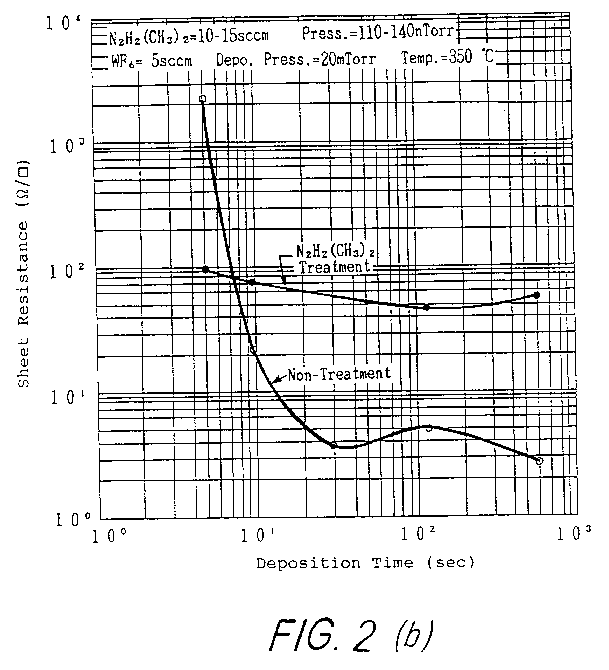

The above reactions will be explained with reference to Fig. 2(a).

In Fig. 2(a), generated free energy ($- \Delta G$) of a reaction formula is plotted against absolute temperature (K). [Refer to Ref. 1) JANA Thermochemical Tables:- (a) 2nd Ed. NSRDS-NBS-37 (1971), (b) 1974 Supplement, (c) 1975 Supplement].

In a reaction in accordance with formula (2), for example, $- \Delta G$ becomes positive at a temperature higher than 600K and therefore the reaction proceeds in the direction of the arrowed line in formula (2). In a reaction in accordance with formula (1), since $- \Delta G$ is negative at 1050K or less, when the reactions in accordance with formulas (1) and (2) are concerted reactions, the reaction of formula (2) occurs preferentially. Namely, the Si substrate surface is cleaned.

The following reaction may be noted:-

$$(2/3)N_2H_4 + Si \longrightarrow (1/3)Si_3N_4 + (4/3)H_2 \quad (5)$$

The reaction of formula (5) may be considered, but direct nitrogenation of Si does not occur even when $NH_3$ is used, if the temperature is lower than 1000°C. Moreover, since $- \Delta G$ becomes positive at 700K or higher in the reaction,

$$Si_3N_4 + N_2H_4 \longrightarrow N_2 + SiH_4 \quad (6)$$

the reaction (5) does not actually occur at 700K or higher, and therefore nitride is not generated. Namely, the Si substrate surface is cleaned.

In the case of the reaction of formula (4), since $- \Delta G$ is negative at all temperatures considered, this reaction seems to be difficult to promote. However, since an oxide at the surface does not have a thermally stable structure such as that of $Al_2O_3$ but is a natural oxide of weak coupling force such as $Al_xO_y$, the following reaction occurs easily:-

$$N_2H_4 + Al_xO_y \longrightarrow N_2 + Al + H_2O.$$

It will therefore be understood that the Si substrate is cleaned, when the above reactions are considered.

Next, the effect of a surface-cleaning process using $N_2H_2(CH_3)_2$, in accordance with an embodiment of the present invention, will be explained with reference to Fig. 2(b).

Fig. 2(b) gives a plot of values of sheet resistance corresponding to film thickness of tungsten deposited at the substrate surface against contact time with $WF_6$ ambient, when the Si substrate is kept at 350°C, after surface treatment using $N_2H_2(CH_3)_2$. The substrate is exposed to the $WF_6$ ambient without contact to atmospheric ambient.

In addition, for the purpose of comparison, values of sheet resistance for a substrate which has not undergone surface treatment using $N_2H_2(CH_3)_2$ are also depicted.

The substrate which has undergone surface-cleaning treatment using $N_2H_2(CH_3)_2$ shows a constant sheet resistance, substantially unaffected by time of contact with $WF_6$ ambient. However, a tungsten layer practically does not grow on the substrate which has not undergone surface treatment using $N_2H_2(CH_3)_2$ when the time for contact with the $WF_6$ ambient is only 5 seconds, namely the sheet resistance value thereof is equal to the value for the Si substrate and it becomes about 4 $\Omega/\square$ as the contact becomes longer.

In general, the reducing reaction of formula (7) occurs between $WF_6$ and Si:-

$$WF_6 + (3/2)Si \longrightarrow W + (3/2)SiF_4 \quad (7)$$

Thereby, tungsten is deposited and the reaction is complete when the disposed (exposed) area of Si disappears. [For example, refer to Ref. 2) "Tungsten and Other Refractory Metals for VLSI Applications", Vols. I-IV, Pitsburgh, PA, U.S.A. (1986-1989)]. The provision of constant sheet resistance, unrelated to contact time with $WF_6$, indicates that efficient surface cleaning has been provided. Namely, the effect of surface-cleaning treatment by $N_2H_2(CH_3)_2$ is clearly demonstrated.

If an oxide exists at the Si substrate surface, $WF_6$ invades into the Si substrate from the gap thereof and the film thickness of tungsten generated by the reaction of formula (7) becomes large. [Refer to Ref. 3) H. H. Busta and C. H. Tang; J. Electrochem. Soc., Vol. 133, page 1195 (1986); Ref. 4) T. Ohba, Y. Ohyama, S. Inoue and M. Maeda; Ref. 2) Vol. II, page 59 (1987)].

For the purpose of comparison, a surface-cleaning process using a reducing reaction employing $H_2$, followed by a deposition of tungsten using $WF_6$, was carried out. The results were assess by measurement of sheet resistance. The results ranged from 30 to 80 $\Omega/\square$ and these values are almost equal to those obtained using a surface-cleaning process employing $N_2H_2(CH_3)_2$ in accordance with an embodiment of the present invention. However, for the surface-cleaning treatment using a reducing reaction employing $H_2$, the substrate temperature is set to 700°C and it is high in comparison with the substrate temperature of 350°C in the case of the surface-cleaning treatment using $N_2H_2(CH_3)_2$.

As described above, a substrate surface contaminant is reduced by $N_2H_4$ and can be eliminated from the surface. This condition, with contaminant eliminated, is shown in Fig. 3(b).

## Second Embodiment:

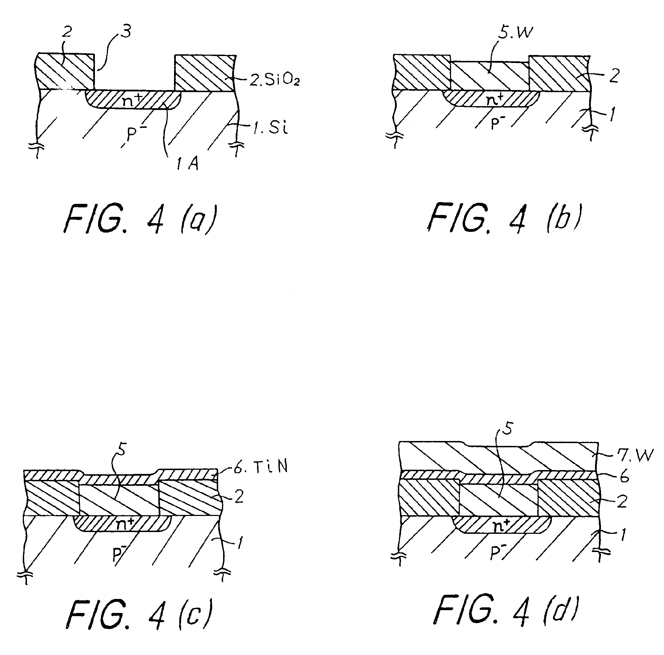

In the apparatus of Fig. 1(a), a contact metal layer is formed on a sample as shown in Fig. 4(a) which has undergone surface-cleaning treatment of the substrate 1 as indicated in Fig. 3(b). The effects of the surface-cleaning treatment are apparent through a comparison of contact characteristics with those obtained using previously proposed methods.

As shown in Fig. 4(b), the tungsten layer 5 is selectively grown by a CVD method using $WF_6$ to a thickness of 4000 Å within the contact hole 3. A typical condition for growth of tungsten is as follows:-

The flow rates of $N_2H_4$ and $WF_6$, as the reaction gases, are respectively set to 10 SCCM, 15 SCCM, and the flow rate of $H_2$ as carrier gas is set to 50 SCCM. The pressure in the reaction chamber 21 is set to 0.1 Torr, while the substrate temperature is set to 300°C.

Chemical reactions in relation to growth of tungsten are as follows:-

$$(3/2)N_2H_4 + WF_6 \longrightarrow (3/2)N_2 + HF + W$$

$$(- \Delta G = 109.35 \text{ kcal/mol at 600K}) \quad (8)$$

Next, as shown in Fig. 4(c), supply of $WF_6$ is changed to $TiCl_4$ and a TiN layer (or Ti layer) 6 is formed to a thickness of 500 Å as an adhesion layer on the entire surface of Fig. 4(b).

Growth of the TiN layer is carried out under the following conditions:-

As reactant gas, flow rates of $TiCl_4$ and $N_2H_4$ are set to 10 SCCM and the flow rate of $H_2$ as carrier gas is set to 100 SCCM. The pressure in the reaction chamber is set to 0.2 Torr. The substrate temperature is set in the range from 400°C to 800°C but desirably set in the range from 500°C to 700°C.

At a substrate temperature of 600°C, the following chemical reaction occurs:-

$$N_2H_4 + TiCl_4 \longrightarrow TiN + (1/2)N_2 + 4HCl$$

$$(- \Delta G = 70.3 \text{ kcal/mol at 900K}) \quad (9)$$

For instance, when the substrate temperature is 500°C or less,

$$N_2H_4 + TiCl_4 \longrightarrow TiN + (1/2)N_2 + 4HCl$$

$$(- \Delta G = 70.3 \text{ kcal/mol at 500K}) \quad (10)$$

Next, as indicated by Fig. 4(d), supply of $TiCl_4$ is changed again to $WF_6$, and a tungsten layer is grown to a thickness of 3000 Å over the entire surface of TiN layer 6 under the same conditions as for the growth of the tungsten layer 5, and a tungsten wiring layer 7 is formed by patterning this tungsten layer.

Evaluation of the quality of the contact thus provided will be explained hereunder.

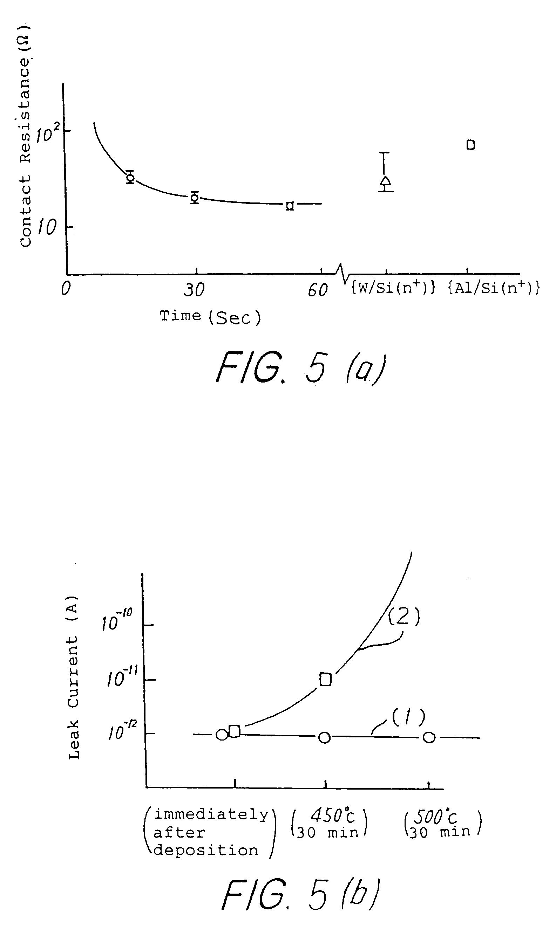

For a W/Si(n⁺) contact, formed by a tungsten layer on n-type Si, in accordance with an embodiment of the present invention, the relationship between contact resistance (R) per 1 μm x 1 μm and surface-cleaning treatment time is indicated in Fig. 5(a).

In Fig. 5(a), for the purpose of comparison, contact resistance values obtained in a case of surface treatment carried out for 10 to 20 seconds using a diluted (1%) solution of hydrogen fluoride (HF) for the same type of contact W/Si(n⁺), and contact resistance values obtained in a case of surface-cleaning treatment carried out on a different kind of contact Al/Si(n⁺) are indicated.

As can be seen in Fig. 5(a), contact resistance values relating to an embodiment of the invention become smaller as the surface-cleaning treatment is carried out for longer times and a minimum contact resistance value can be obtained using a method in accordance with an embodiment of the present invention wherein surface treatment time is 30 seconds or longer.

Fig. 5(b) indicates relationships between a leakage current of a diode and annealing time, in relation to a W/Si(n⁺) contact provided in accordance with an embodiment of the invention as for Fig. 5(a), and in relation to the contact Al/Si(n⁺) of Fig. 5(a).

The leakage currents of the W/Si(n⁺) contact immediately after formation of the tungsten layer on a surface treated by $N_2H_4$, after annealing at 450°C for 30 minutes and after annealing at 500°C for 30 minutes, are indicated by curve (1) in Fig. 5(b). Moreover, for the Al/Si(n⁺) contact, leakage currents obtained immediately after growth of Al, after annealing at 450°C for 30 minutes and after annealing at 500°C for 30 minutes, after carrying out surface cleaning using HF, are indicated by curve (2). As will be understood from Fig. 5, leakage current of the W/Si(n⁺) contact in accordance with this embodiment of the invention is smaller than that of the Al/Si(n⁺) contact and is also smaller than that obtained by annealing at 450°C or higher, by an order of magnitude or more.

## Third Embodiment

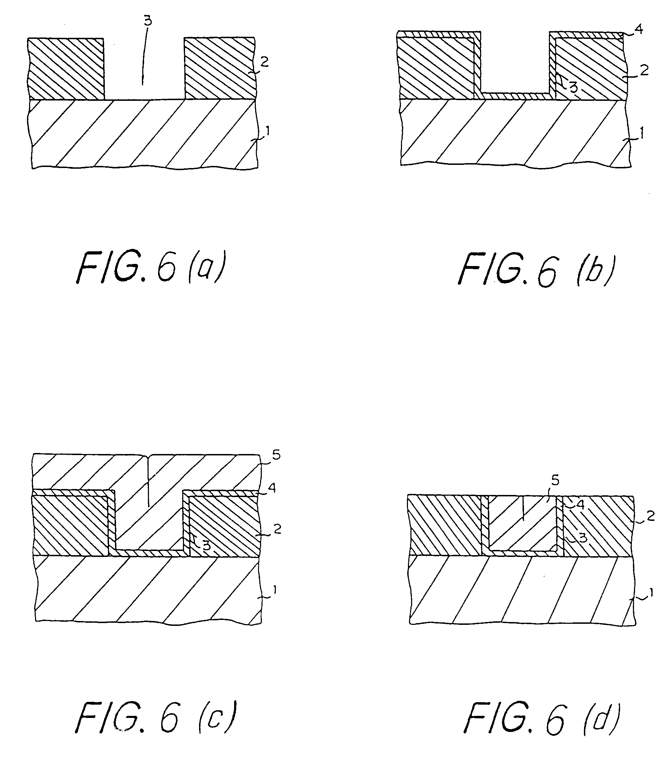

Fig. 6(a) indicates a sample wherein an insulating interlayer film 2 is formed by depositing PSG (phosphosilicate glass) to a thickness of about 5000 Å on a silicon substrate 1, for example by the CVD method, and thereafter a contact hole with a width of 5000 Å is formed through selective etching of the insulating interlayer film 2, for example by RIE (reactive ion etching), and the cleaning process is carried out in respect of the surface of substrate 1 as shown in Fig. 3(b) within the apparatus of Fig. 1(a), in accordance with an embodiment of the present invention. The other method for forming the tungsten contact layer to the sample shown in Fig. 6(a) in the apparatus of Fig. 1(a).

As shown in Fig. 6(b), a TiN barrier metal layer 4 is formed to a thickness of about 500 Å on the contact hole 3 and interlayer insulating film 2. The TiN barrier metal layer 4 is formed by a CVD method, not by a sputtering method as previously proposed. A typical condition for the CVD is as follows:-

As reaction gas, $TiCl_4$ is introduced at 5 SCCM and $N_2H_4$ at 20 SCCM, while as carrier gas, $H_2$ is introduced at 50 SCCM, respectively into the reaction chamber together. Pressure is set to 0.1 to 1.0 Torr and substrate temperature is kept at 600°C.

Next, as shown in Fig. 6(c), a tungsten contact layer 5 is formed to a thickness of about 5000Å on the TiN barrier metal layer 4. This is carried out in the same reaction chamber by exchanging reactant gas and carrier gas. A typical condition for this CVD is as follows:-

As reaction gas, $WF_6$ is introduced at 10 SCCM and $N_2H_4$ at 10 SCCM, while as carrier gas, He is introduced at 100 SCCM, respectively to the reaction chamber together. Pressure is set to 0.1 to 10 Torr and substrate temperature is kept at 380°C.

Finally, the sample is taken out from the apparatus of Fig. 1(a) and the wiring structure as shown in Fig. 6(d), burying the TiN barrier metal layer 4 and tungsten contact layer 5, can be obtained in the contact hole 3 by etching the tungsten contact layer 5 and TiN barrier metal layer 4 using, for example, a RIE (reactive ion etching) method.

Since the contact layer is formed by a CVD method, unlike the previously proposed sputtering method, in order to form the wiring structure indicated in this embodiment, the TiN barrier metal layer 4 is more dense than the layer provided with the previously proposed method and coverage of the contact hole 3 is also good. This can also be said of the tungsten contact layer 5. Moreover, since reactive side products are not incorporated into the metal layer, the relevant layer has a low specific resistance.

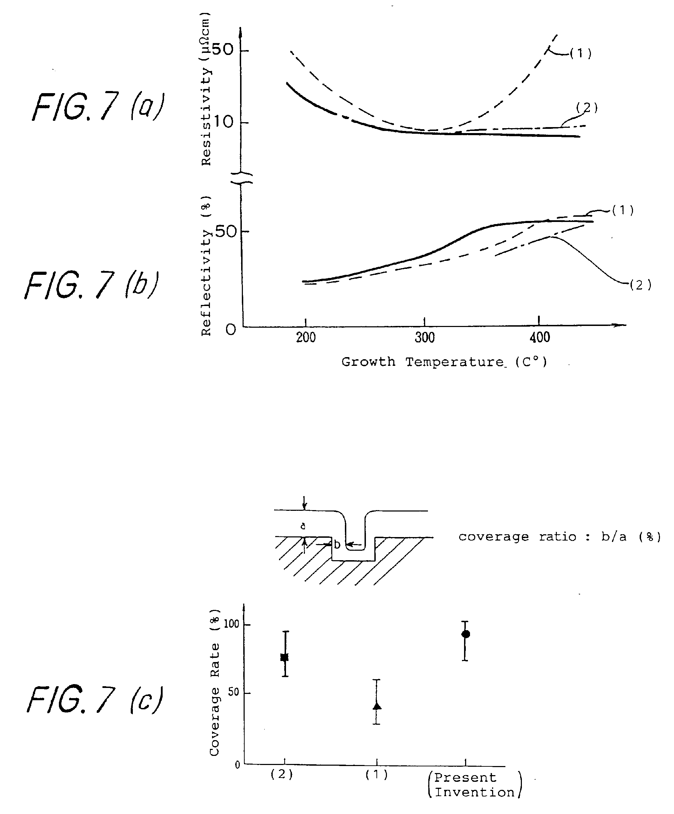

Figs. 7(a), 7(b) are graphs representing an evaluation of the tungsten layer 5 manufactured by the steps shown in Fig. 6.

Fig. 7(a) is a graph plotting specific resistance of tungsten layer 5, while Fig. 7(b) is a graph plotting reflectivity of tungsten layer 5 to Al, respectively for the growth temperature (substrate temperature) of CVD. In Figs. 7(a), 7(b), the curves indicated by solid lines correspond to layers manufactured by the steps of Fig. 6, while the curves indicated by broken lines (1) correspond to tungsten contact layers manufactured by a previously proposed reducing reaction using $SiH_4$ and the graphs indicated by chain lines (2) correspond to tungsten layers manufactured by a previously proposed reducing reaction using $H_2$. The CVD growth condition for the reducing reaction using $SiH_4$ is that a mixed gas including $WF_6$ at 5 SCCM, $SiH_4$ at 5 SCCM and $H_2$ at 100 SCCM is used under a pressure of 0.1 Torr. The CVD growth condition for the reducing reaction using $H_2$ is that a mixed gas including $WF_6$ at 10 SCCM and $H_2$ at 1000 SCCM is used under a pressure of 5 Torr).

As can be understood from Fig. 7(a) and 7(b), a tungsten layer having small resistivity and large reflectivity simultaneously cannot be obtained with the previously proposed methods. However, in the embodiment of the present invention, when the growth temperature is about 350 to 450°C, a tungsten layer is formed which has a smaller resistivity value and simultaneously larger reflectivity than provided by layers formed with the previously proposed methods.

Fig. 7(c) provides a comparison of the coverage ratio of a contact hole formed with a tungsten layer formed by a manufacturing method in accordance with an embodiment of the invention with those provided by previously proposed methods (1) and (2). The previously proposed methods (1) and (2) are the same as those mentioned in relation to Figs. 7(a) and 7(b). The coverage ratio is expressed, as illustrated in the upper part of Fig. 7(c), by a percentage indication of the ratio of thickness on a side wall of a contact hole and thickness on the substrate. The coverage ratio provided by the method embodying the present invention is larger than that provided by the previous proposals. The coverage ratio can further be improved by reducing the flow rate of $N_2H_4$ with respect to that of $WF_6$, for example $WF_6/N_2H_4 = 10/2$.

In the described method of this third embodiment of the present invention, a tungsten layer is formed on the TiN barrier layer. However, a Cu layer can alternatively be formed on the TiN barrier layer. In this case, the Cu layer may be formed by using a Cu halide, such as the $WF_6$ used for formation of the tungsten layer, as reaction gas. Alternatively, a metal complex gas such as $Cu(HFA)_2$ may be used.

Fourth Embodiment:

Next, an example of formation of a contact with multilayer wiring, manufactured using the apparatus of Figs. 1(a), 1(b) or 1(c), will be explained.

In Fig. 8(a) to Fig. 8(d), processes for forming the contact with multilayer wirings are explained in schematic sectional views.

Fig. 8(a) to Fig. 8(f) indicate the same series of processes as shown in Fig. 3(a) to Fig. 3(b), followed by the processes shown in Fig. 4(a) to Fig. 4(d).

When the process shown in Fig. 8(d) is completed, the sample is once taken out of the manufacturing apparatus of Figs. 1(a), 1(b) or 1(c).

Next, as shown in Fig. 8(e), an $SiO_2$ film 8 is formed to a thickness of 4000 Å, as an insulating interlayer covering the tungsten wiring 7, and a contact hole 9 is then opened therein. The sample is then set in the reaction chamber of the manufacturing apparatus of Fig. 1(a), 1(b) or 1(c) and surface treatment such as that conducted in Fig. 3(a) is conducted for 30 to 60 seconds. Thereby, impurity or oxide 10 adhered or remaining on the tungsten wiring 7 in the contact hole 9 can be eliminated.

Finally, as shown in Fig. 8(f), the tungsten layer 11 is grown to a thickness of about 4000 Å in the contact hole 9 by a method similar to that in Fig. 3(b). Thereafter, the reaction gas $WF_6$ is immediately changed, for example, to $AlCl_3$ and an Al layer 12, as a second wiring layer, is grown on to the entire surface. For the formation of the Al layer, $Al(CH_3)_3$ or $Al(i-C_4H_9)_3$ may be used in place of $AlCl_3$.

As explained above, the one contact with multilayer wirings can be formed.

In above-described embodiments, $WF_6$, $TiCl_4$ are used as metal halide gas. However, a halogenide of molybdenum (Mo), vanadium (V), zirconium (Zr), gold (Au), copper (Cu) and platinum (Pt) may also be used. In addition, as organic metal or metal complex, tungsten carbonyl ($W(Co)_6$), copper hexafluoroacetylacetone ($Cu(HFA)_2$), gold hexafluoroacetylacetone ($Au(HFA)$) and other complexes including Ti or Zr can also be used.

Moreover, as the nitrogen hydride, $N_2H_4$ is mainly used but $N_2H_2$, $N_5H_5$ can also be used. As derivatives of nitrogen hydride employable in embodiments of the present invention, $N_2H(CH_3)_3$, $N_2H_2(CH_3)_2$, $N_2H_3(CH_3)$ and $N_5H_4(CH_3)$ can also be used.

An embodiment of the present invention provides a method of forming metal contact wiring layers in semiconductor devices by cleaning the surface of exposed substrate of a contact hole formed in an $SiO_2$ film on a semiconductor substrate, which cleaning employs the reducing effect of $N_2H_4$ gas, thereafter forming a TiN barrier layer by a CVD method using a mixed gas of $N_2H_4$ and $TiCl_4$ while the surface is not exposed to air, then forming a tungsten contact layer thereon by a CVD method using a mixed gas of $N_2H_4$ and $WF_6$, or forming the TiN layer by a CVD method on a tungsten contact layer formed by a CVD method directly on the substrate.

## Claims

1. A method of manufacturing a contact on a substrate surface, including forming a conducting material layer on an exposed surface region of the substrate structure, which exposed surface region may be that of a semiconductor or conductor material of the substrate structure, and cleaning an exposed surface region of the substrate, prior to forming the conducting material layer, using a gas comprising a nitrogen hydride or a nitrogen hydride derivative, then forming the conducting material layer containing a metal on the substrate using a gas mixture containing a gas comprising a nitrogen hydride or a nitrogen hydride derivative and a gas comprising a metal halide or an organic metal composition or a metal complex, without intermediate exposure of the substrate to atmospheric conditions.

2. A method as claimed in claim 1, wherein the cleaning is performed at a temperature such that nitrogenation of the exposed substrate region is substantially avoided.

3. A method as claimed in claim 2, wherein the said temperature is between 200°C and 900°C, and preferably between 300°C and 600°C.

4. A method as claimed in claim 1, 2 or 3, wherein the so-formed conducting material layer contains nitrogen.

5. A method as claimed in claim 1, 2 or 3, wherein the forming of the conducting material layer is effected a temperature lower than 600°C, such that metal is deposited on the substrate.

6. A method as claimed in claim 4, wherein the forming of the conducting material layer is effected at a temperature preferably between 300°C and 700°C, or higher than 400°C, such that metal containing nitrogen is deposited on the substrate.

7. A method as claimed in any preceding claim, wherein a further conducting material layer containing a metal is formed using a gas mixture containing a gas comprising a nitrogen hydride or a nitrogen hydride derivative and a gas comprising a metal halide or an organic metal composition or a metal complex.

8. A method as claimed in any preceding claim, wherein cleaning and the formation(s) of the conducting material layer(s) are performed in the same gas chamber.

9. A method as claimed in any of claims 1 to 7, wherein cleaning and the formation(s) of the conducting material layer(s) are performed successively in different gas chambers, connected through a connecting chamber.

10. A method as claimed in any preceding claim, wherein the or each said metal is selected from the group consisting of tungsten (W), titanium (Ti), molybdenum (Mo), vanadium (V), zirconium (Zr), gold (Au), copper (Cu), and platinum (Pt).

11. A method as claimed in any preceding claim, wherein the or each said gas mixture contains a gas comprising a metal halide selected from the group consisting of tungsten hexafluoride ($WF_6$), titanium tetrachloride ($TiCl_4$) and halides of Mo, V, Zr, Au, Cu and Pt.

12. A method as claimed in any of claims 1 to 10, wherein the or each said gas mixture contains a gas comprising a metal complex selected from the group consisting of tungsten carbonyl (W(Co)$_6$), copper hexafluoroacetylacetone (Cu(HFA)$_2$), gold hexafluoroacetylacetone (Au(HFA)) and complexes of Ti and Zr.

13. A method as claimed in any preceding claim, wherein each molecule of the nitrogen hydride or the nitrogen hydride derivative employed contains more than two nitrogen atoms.

14. A method as claimed in any one of claims 1 to 12, wherein hydrazine (N$_2$H$_4$) is used as the nitrogen hydride.

15. A method as claimed in any one of claims 1 to 12, wherein dimethyl hydrazine (CH$_3$)$_2$N$_2$H$_2$ or monomethyl hydrazine (CH$_3$)N$_2$H$_3$ is used as the nitrogen hydride derivative.

16. A method as claimed in any preceding claim, wherein the substrate has a base of silicon.

17. A method as claimed in any preceding claim, wherein a region of the substrate is exposed through an insulating layer formed on the substrate.

18. A method as claimed in claims 8 or 9, said method comprising the steps of:-
(a) cleaning an exposed surface region of a silicon substrate at the bottom of a contact hole formed in a silicon dioxide film on said silicon substrate, said silicon substrate being heated at a temperature between 200 and 900°C, more preferably 300°C, using a mixed gas of hydrazine at a flow of 10 SCCM and hydrogen at a flow of 10 SCCM;
(b) forming a tungsten (W) layer on said exposed surface region of the silicon substrate at the bottom of said contact hole at about 300°C by CVD (chemical vapour deposition), using a mixed gas of WF$_6$ at a flow of 15 SCCM, N$_2$H$_4$ at 10 SCCM and H$_2$ at 50 SCCM;
(c) forming a TiN layer on said tungsten (W) layer at a temperature between 500 and 600°C, preferably at about 600°C, by CVD using a mixed gas of TiCl$_4$ at a flow of 10 SCCM, N$_2$H$_4$ at 10 SCCM and H$_2$ at 50 SCCM;
(d) patterning a further tungsten (W) layer under atmospheric conditions, which further tungsten (W) layer is formed on said TiN layer under the same conditions as those of step (b);
(e) cleaning an exposed surface region of the further tungsten (W) layer at the bottom of a contact hole formed in a silicon dioxide film formed on the further tungsten (W) layer, under the same conditions as those of step (a); and
(f) forming a tungsten (W) layer on said exposed surface region at the bottom of said contact hole, under the same conditions of step (b).

**Patentansprüche**

1. Ein Verfahren zum Herstellen eines Kontaktes auf einer Substratoberfläche, mit dem Bilden einer Schicht aus leitendem Material auf einer exponierten Oberflächenzone der Substratstruktur, welche exponierte Oberflächenzone jene von einem Halbleiter- oder Leitermaterial der Substratstruktur sein kann, und dem Reinigen einer exponierten Oberflächenzone des Substrats, vor dem Bilden der Schicht aus leitendem Material, unter Verwendung eines Gases, das ein Stickstoffhydrid oder ein Stickstoffhydridderivat umfaßt, dann dem Bilden der Schicht aus leitendem Material, das ein Metall enthält, auf dem Substrat unter Verwendung eines Gasgemischs, das ein Gas enthält, das ein Stickstoffhydrid oder ein Stickstoffhydridderivat umfaßt, und ein Gas, das ein Metallhalogenid oder eine organische Metallzusammensetzung oder einen Metallkomplex umfaßt, ohne das Substrat in der Zwischenzeit atmosphärischen Bedingungen auszusetzen.

2. Ein Verfahren nach Anspruch 1, bei dem das Reinigen bei solch einer Temperatur erfolgt, daß eine Nitrierung der exponierten Oberflächenzone im wesentlichen vermieden wird.

3. Ein Verfahren nach Anspruch 2, bei dem die genannte Temperatur zwischen 200°C und 900°C und vorzugsweise zwischen 300°C und 600°C liegt.

4. Ein Verfahren nach Anspruch 1, 2 oder 3, bei dem die so gebildete Schicht aus leitendem Material Stickstoff enthält.

5. Ein Verfahren nach Anspruch 1, 2 oder 3, bei dem das Bilden der Schicht aus leitendem Material bei einer Temperatur unter 600°C ausgeführt wird, so daß auf dem Substrat Metall abgeschieden wird.

6. Ein Verfahren nach Anspruch 4, bei dem das Bilden der Schicht aus leitendem Material vorzugsweise bei einer Temperatur zwischen 300°C und 700°C oder über 400°C ausgeführt wird, so daß auf dem Substrat metallhaltiger Stickstoff abgeschieden wird.

7. Ein Verfahren nach irgendeinem vorhergehenden Anspruch, bei dem eine weitere Schicht aus leitendem Material, das ein Metall enthält, unter Verwendung eines Gasgemischs gebildet wird, das ein Gas mit einem Stickstoffhydrid oder einem Stickstoffhydridderivat und ein Gas mit einem Metallhalogenid oder einer organischen Metallzusammensetzung oder einem Metallkomplex enthält.

8. Ein Verfahren nach irgendeinem vorhergehenden Anspruch, bei dem das Reinigen und das Bilden der Schicht(en) aus leitendem Material in derselben Gaskammer ausgeführt werden.

9. Ein Verfahren nach irgendeinem der Ansprüche 1 bis 7, bei dem das Reinigen und das Bilden der Schicht(en) aus leitendem Material sukzessive in verschiedenen Gaskammern ausgeführt werden, die durch eine Verbindungskammer verbunden sind.

10. Ein Verfahren nach irgendeinem vorhergehenden Anspruch, bei dem das oder jedes genannte Metall ausgewählt ist aus der Gruppe bestehend aus Wolfram (W), Titan (Ti), Molybdän (Mo), Vanadium (V), Zirconium (Zr), Gold (Au), Kupfer (Cu) und Platin (Pt).

11. Ein Verfahren nach irgendeinem vorhergehenden Anspruch, bei dem das oder jedes genannte Gasgemisch ein Gas mit einem Metallhalogenid enthält, das ausgewählt ist aus der Gruppe bestehend aus Wolframhexafluorid ($WF_6$), Titantetrachlorid ($TiCl_4$) und Halogeniden von Mo, V, Zr, Au, Cu und Pt.

12. Ein Verfahren nach irgendeinem der Ansprüche 1 bis 10, bei dem das oder jedes genannte Gasgemisch ein Gas mit einem Metallkomplex enthält, der ausgewählt ist aus der Gruppe bestehend aus Wolframcarbonyl ($W(Co)_6$), Kupferhexafluoroacetylaceton ($Cu(HFA)_2$), Goldhexafluoroacetylaceton ($Au(HFA)$) und Komplexen von Ti und Zr.

13. Ein Verfahren nach irgendeinem vorhergehenden Anspruch, bei dem jedes Molekül des verwendeten Stickstoffhydrids oder Stickstoffhydridderivats mehr als zwei Stickstoffatome enthält.

14. Ein Verfahren nach irgendeinem der Ansprüche 1 bis 12, bei dem Hydrazin ($N_2H_4$) als Stickstoffhydrid verwendet wird.

15. Ein Verfahren nach irgendeinem der Ansprüche 1 bis 12, bei dem Dimethylhydrazin $(CH_3)_2N_2H_2$ oder Monomethylhydrazin $(CH_3)N_2H_3$ als Stickstoffhydridderivat verwendet wird.

16. Ein Verfahren nach irgendeinem vorhergehenden Anspruch, bei dem das Substrat eine Basis aus Silizium hat.

17. Ein Verfahren nach irgendeinem vorhergehenden Anspruch, bei dem eine Zone des Substrats durch eine Isolierschicht, die auf dem Substrat gebildet ist, exponiert.

18. Ein Verfahren nach Anspruch 8 oder 9, welches Verfahren die Schritte umfaßt:-

(a) Reinigen einer exponierten Oberflächenzone eines Siliziumsubstrats auf dem Boden eines Kontaktloches, das in einem Siliziumdioxidfilm auf dem genannten Siliziumsubstrat gebildet ist, wobei das genannte Siliziumsubstrat auf eine Temperatur zwischen 200 und 900°C, vorzugsweise auf 300°C, aufgeheizt ist, unter Verwendung eines Gasgemischs aus Hydrazin mit einem Fluß von 10 SCCM und Wasserstoff mit einem Fluß von 10 SCCM;

(b) Bilden einer Wolfram-(W)-Schicht auf der genannten exponierten Oberflächenzone des Siliziumsubstrats auf dem Boden des genannten Kontaktloches bei etwa 300°C durch CVD (chemische Dampfabscheidung) unter Verwendung eines Gasgemischs aus $WF_6$ mit einer Flußmenge von 15 SCCM, $N_2H_4$ mit 10 SCCM und $H_2$ mit 50 SCCM;

(c) Bilden einer TiN-Schicht auf der genannten Wolfram-(W)-Schicht bei einer Temperatur zwischen 500 und 600°C, vorzugsweise bei etwa 600°C, durch CVD unter Verwendung eines Gasgemischs aus $TiCl_4$ mit einer Flußmenge von 10 SCCM, $N_2H_4$ mit 10 SCCM und $H_2$ mit 50 SCCM;

(d) Mustern einer weiteren Wolfram-(W)-Schicht unter atmosphärischen Bedingungen, welche weitere Wolfram-(W)-Schicht auf der genannten TiN-Schicht unter denselben Bedingungen wie bei Schritt (b) gebildet wurde;

(e) Reinigen einer exponierten Oberflächenzone der weiteren Wolfram-(W)-Schicht auf dem Boden eines Kontaktloches, das in einem Siliziumdioxidfilm gebildet ist, der auf der weiteren Wolfram-(W)-Schicht gebildet wurde, unter denselben Bedingungen wie bei Schritt (a); und

(f) Bilden einer Wolfram-(W)-Schicht auf der genannten exponierten Oberflächenzone auf dem Boden des genannten Kontaktloches unter denselben Bedingungen wie bei Schritt (b).

## Revendications

1. Procédé de fabrication d'un contact sur une surface de substrat, qui comprend de former une couche de matériau conducteur sur une région de surface exposée de la structure de substrat, cette région de surface exposée peut être une région de semi-conducteur ou de matériau conducteur de la structure de substrat, et de nettoyer la région de surface exposée du substrat, avant de former la couche de matériau conducteur, utiliser un gaz comprenant un hydrure d'azote ou un dérivé d'hydrure d'azote, puis former la couche de matériau conducteur contenant un métal sur le substrat en utilisant un mélange gazeux contenant un gaz comprenant un hydrure d'azote ou un dérivé d'hydrure d'azote et un gaz comprenant un halogénure métallique ou une composition organométallique ou un complexe métallique, sans exposition intermédiaire du substrat aux conditions atmosphériques.

2. Procédé selon la revendication 1, dans lequel on réalise le nettoyage à une température telle qu'on évite sensiblement la nitruration de la région de substrat exposé.

3. Procédé selon la revendication 2, dans lequel ladite température est comprise entre 200 et 900°C, et de préférence entre 300°C et 600°C.

4. Procédé selon la revendication 1, 2 ou 3, dans lequel la couche de matériau conducteur ainsi formée contient de l'azote.

5. Procédé selon la revendication 1, 2 ou 3, dans lequel on réalise la formation de la couche de matériau conducteur à une température inférieure à 600°C, de façon à déposer le métal sur le substrat.

6. Procédé selon la revendication 4, dans lequel on réalise la formation de la couche de matériau conducteur à une température choisie de préférence entre 300°C et 700°C, ou supérieure à 400°C, de sorte qu'on dépose du métal contenant de l'azote sur le substrat.

7. Procédé selon l'une quelconque des revendications précédentes, dans lequel on forme une autre couche de matériau conducteur contenant un métal en utilisant un mélange gazeux contenant un gaz comprenant un hydrure d'azote ou un dérivé d'hydrure d'azote et un gaz comprenant un halogénure métallique ou une composition organométallique ou un complexe métallique.

8. Procédé selon l'une quelconque des revendications précédentes, dans lequel on réalise le nettoyage et la ou les formation(s) de la ou des couche(s) de matériau conducteur dans la même chambre à gaz.

9. Procédé selon l'une quelconque des revendications 1 à 7, dans lequel le nettoyage et la ou les formation(s) de la ou des couche(s) de matériau conducteur sont réalisés successivement dans différentes chambres à gaz, reliées par une chambre de liaison.

10. Procédé selon l'une quelconque des revendications précédentes, dans lequel le ou chacun desdits métaux est choisi dans le groupe constitué du tungstène (W), du titane (Ti), du molybdène (Mo), du vanadium (V), du zirconium (Zr), de l'or (Au), du cuivre (Cu) et du platine (Pt).

11. Procédé selon l'une quelconque des revendications précédentes, dans lequel le gaz ou chacun desdits mélanges de gaz contient un gaz comprenant un halogénure métallique choisi dans le groupe constitué de l'hexafluorure de tungstène ($WF_6$), du tétrachlorure de titane ($TiCl_4$) et des halogénures de Mo, V, Zr, Au, Cu et Pt.

12. Procédé selon l'une quelconque des revendications 1 à 10, dans lequel le mélange de gaz ou chaque mélange de gaz contient un gaz comprenant un complexe métallique choisi dans le groupe constitué du tungstène carbonyle ($W(Co)_6$), de l'hexafluoroacétylacétone de cuivre ($Cu(HFA)_2$), de l'hexafluoroacétylacétone d'or ($Au(HFA)$) et des complexes de Ti et Zr.

13. Procédé selon l'une quelconque des revendications précédentes, dans lequel chaque molécule d'hydrure d'azote ou de dérivés d'hydrure d'azote utilisée contient plus de deux atomes d'azote.

14. Procédé selon l'une quelconque des revendications 1 à 12, dans lequel on utilise l'hydrazine ($N_2H_4$) comme hydrure d'azote.

15. Procédé selon l'une quelconque des revendications 1 à 12, dans lequel on utilise la diméthylhydrazine ($(CH_3)_2N_2H_2$) ou la monométhylhydrazine ($(CH_3)N_2H_3$) comme dérivé d'hydrure d'azote.

16. Procédé selon l'une quelconque des revendications précédentes, dans lequel le substrat a une base de silicium.

17. Procédé selon l'une quelconque des revendications précédentes, dans lequel on expose une région du substrat par l'intermédiaire d'une couche isolante formée sur le substrat.

18. Procédé selon les revendications 8 ou 9, ledit procédé comprenant les étapes de :

(a) nettoyer une région de surface exposée d'un substrat de silicium au fond d'un trou de contact formé dans un film de dioxyde de silicium sur ledit substrat de silicium, ledit substrat de silicium étant chauffé à une température comprise entre 200 et 900°C, de préférence à 300°C, en utilisant un gaz mixte d'hydrazine à un débit de 10 SCCM et d'hydrogène à un débit de 10 SCCM (cm³/min dans les conditions standards) ;

(b) former une couche de tungstène (W) sur ladite région de surface exposée du substrat de silicium au fond dudit trou de contact à environ 300°C par CVD (dépôt de vapeur chimique), en utilisant un gaz mixte de WF$_6$ à un débit de 15 SCCM, N$_2$H$_4$ à 10 SCCM et H$_2$ à 50 SCCM ;

(c) former une couche de TiN sur ladite couche de tungstène (W) à une température comprise entre 500 et 600°C, de préférence à environ 600°C, par CVD en utilisant un gaz mixte de TiCl$_4$ à un débit de 10 SCCM, N$_2$H$_4$ à 10 SCCM et H$_2$ à 50 SCCM ;

(d) déposer en formant un motif une autre couche de tungstène (W) dans les conditions atmosphériques, cette autre couche de tungstène (W) est formée sur ladite couche de TiN dans les mêmes conditions que celles de l'étape (b) ;

(e) nettoyer une région de surface exposée de l'autre couche de tungstène (W) au fond d'un trou de contact formé dans un film de dioxyde de silicium formé sur l'autre couche de tungstène (W), dans les mêmes conditions que celles de l'étape (a) ; et

(f) former une couche de tungstène (W) sur ladite région de surface exposée au fond dudit trou de contact, dans les mêmes conditions qu'à l'étape (b).

FIG. 1 (a)

FIG. 1 (b)

FIG. 1 (c)

FIG. 2 (a)

FIG. 2 (b)

FIG. 3 (a)

FIG. 3 (b)

FIG. 4 (a)

FIG. 4 (b)

FIG. 4 (c)

FIG. 4 (d)

FIG. 5 (a)

FIG. 5 (b)

FIG. 6 (a)

FIG. 6 (b)

FIG. 6 (c)

FIG. 6 (d)

FIG. 7 (a)

FIG. 7 (b)

Growth Temperature (C°)

coverage ratio : b/a (%)

FIG. 7 (c)

FIG. 8 (a)

FIG. 8 (b)

FIG. 8 (c)

FIG. 8 (d)

FIG. 8 (e)

FIG. 8 (f)